(19) Europäisches Patentamt
European Patent Office
Office européen des brevets

(11) **EP 3 590 140 B1**

(12) **EUROPEAN PATENT SPECIFICATION**

(45) Date of publication and mention
of the grant of the patent:
**21.10.2020 Bulletin 2020/43**

(51) Int Cl.:
**H01L 41/04** *(2006.01)*     **H01L 41/193** *(2006.01)*

(21) Application number: **18707045.3**

(86) International application number:
**PCT/EP2018/054723**

(22) Date of filing: **27.02.2018**

(87) International publication number:
**WO 2018/158206 (07.09.2018 Gazette 2018/36)**

(54) **ELECTROACTIVE MATERIAL ACTUATOR AND DRIVE METHOD**

AKTORVORRICHTUNG, BETÄTIGUNGSVERFAHREN UND HERSTELLUNGSVERFAHREN

DISPOSITIF D'ACTIONNEUR, PROCÉDÉ D'ACTIONNEMENT ET PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.02.2017 EP 17158318**

(43) Date of publication of application:
**08.01.2020 Bulletin 2020/02**

(73) Proprietor: **Koninklijke Philips N.V.
5656 AG Eindhoven (NL)**

(72) Inventors:
• **HILGERS, Achim**
  **5656 AE Eindhoven (NL)**
• **VAN DEN ENDE, Daan Anton**
  **5656 AE Eindhoven (NL)**
• **JOHNSON, Mark Thomas**
  **5656 AE Eindhoven (NL)**

(74) Representative: **Steenbeek, Leonardus Johannes
Philips Intellectual Property & Standards
High Tech Campus 5
5656 AE Eindhoven (NL)**

(56) References cited:
**EP-A2- 0 995 599     WO-A1-2004/040112**

• **XINGCAN XIANG ET AL: "How the type of input function affects the dynamic response of conducting polymer actuators", SMART MATERIALS AND STRUCTURES, IOP PUBLISHING LTD., BRISTOL, GB, vol. 23, no. 10, 9 September 2014 (2014-09-09), page 105008, XP020271344, ISSN: 0964-1726, DOI: 10.1088/0964-1726/23/10/105008 [retrieved on 2014-09-09]**

**EP 3 590 140 B1**

**Description**

FIELD OF THE INVENTION

This invention relates to electroactive material (EAM) actuators, and methods for driving EAM actuators.

BACKGROUND OF THE INVENTION

Electroactive materials (EAMs) are a class of materials within the field of electrically responsive materials. When implemented in an actuation device, subjecting an EAM to an electrical drive signal can make them change in size and/or shape. This effect can be used for actuation and sensing purposes. There exist inorganic and organic EAMs. A special kind of organic EAMs are electroactive polymers (EAPs).

Electroactive polymers (EAPs) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 1MHz, most typically below 20 kHz.

Devices using electroactive polymers can be subdivided into field-driven and ionic-driven materials.

Examples of field-driven EAPs include Piezoelectric polymers, Electrostrictive polymers (such as PVDF based relaxor polymers) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

This invention relates in particular to field-driven electroactive material actuators.

Field-driven EAPs are actuated by an electric field through direct electromechanical coupling. They usually require high fields (volts per meter) but low currents. Polymer layers are usually thin to keep the driving voltage as low as possible. Ionic EAPs are activated by an electrically induced transport of ions and/or solvent. They usually require low voltages but high currents. They require a liquid/gel electrolyte medium (although some material systems can also operate using solid electrolytes).

Both classes of EAP have multiple family members, each having their own advantages and disadvantages.

A first notable subclass of field-driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field-driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of field-driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrrole (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Changing the charge on the carbon atoms results in changes of C-C bond length. As a result, expansion and contraction of single CNT can be observed.

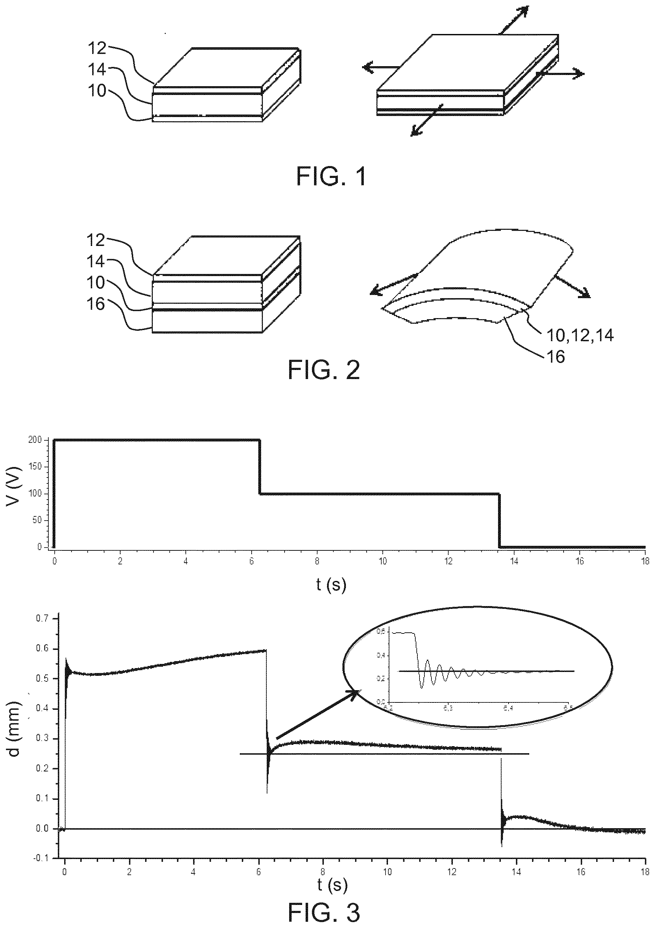

Figures 1 and 2 show two possible operating modes for an EAP device.

The device comprises an electroactive polymer layer 14 sandwiched between electrodes 10, 12 on opposite sides of the electroactive polymer layer 14.

Figure 1 shows a device which is not clamped. A voltage is used to cause the electroactive polymer layer to expand in all directions as shown.

Figure 2 shows a device which is designed so that the expansion arises only in one direction. The device is supported by a carrier layer 16. A voltage is used to cause the electroactive polymer layer to curve or bow.

Together, the electrodes, electroactive polymer layer, and carrier may be considered to constitute the overall electroactive polymer structure.

The nature of this movement for example arises from the interaction between the active layer which expands when actuated, and the passive carrier layer. To obtain the asymmetric curving around an axis as shown, molecular orientation (film stretching) may for example be applied, forcing the movement in one direction.

The expansion in one direction may result from the asymmetry in the EAP polymer, or it may result from asymmetry in the properties of the carrier layer, or a combination of both.

An electroactive polymer structure as described above may be used both for actuation and for sensing. The most prominent sensing mechanisms are based on force measurements and strain detection. Dielectric elastomers, for example, can be easily stretched by an external force. By putting a low voltage on the sensor, the strain can be measured as a function of voltage (the voltage is a function of the area).

Another way of sensing with field-driven systems is measuring the capacitance-change directly or measuring changes in electrode resistance as a function of strain.

Piezoelectric and electrostrictive polymer sensors can generate an electric charge in response to applied mechanical stress (given that the amount of crystallinity is high enough to generate a detectable charge). Conjugated polymers can make use of the piezo-ionic effect (mechanical stress leads to exertion of ions). CNTs experience a change of charge on the CNT surface when exposed to stress, which can be measured. It has also been shown that the resistance of CNTs change when in contact with gaseous molecules (e.g. $O_2$, $NO_2$), making CNTs usable as gas detectors.

When an EAP actuator is activated, a certain time delay caused by the capacitive behavior occurs. Approximately, the EAP-response follows a non-linear, exponential function, which essentially is very similar to the charging curve of a capacitor.

To reach a certain position of the EAP, this capacitive charge needs to reach a corresponding level as well. Such a charging level is reached after a certain multiple of the time constant $\tau$. Usually, after a time duration of $5\tau$, the maximum extension (or end position) is reached. For applications where a fast response is needed with a limited delay time, or a higher frequency of operation is required, this behavior might be a disadvantage and would hinder the usage of EAPs.

Electro Active Polymers (EAPs) can be used in several applications where different requirements in terms of precision may exist. For example, if used as a simple haptic feedback device it is not important how the EAP reacts; it may be sufficient that it reacts at all and hence a feedback is given. However, in certain applications a very high precision may be required, where the EAP needs to be deactivated, or partially deactivated, very accurately. In such cases, ideally a step-like mechanical deformation is desired. This would be the case, for example, if the EAP is to be used as an on-off switch. As a function of the input signal, the EAP needs to change its mechanical state from a first (activated) state to a second (deactivated or partially deactivated) state. Alternatively, there are applications where actuation without jitter is required for example in steering devices such as catheters.

However for some EAPs, a very specific behavior has been observed. If operated by a rectangular driving voltage, the mechanical deformation (deactivation) shows a very strong oscillating performance as presented in Figure 3.

The top image shows the actuation voltage versus time, and the bottom image shows the mechanical response versus time. This may result in significant problems in some applications such as where very precise on-off states need to be provided. Usually a certain threshold value to separate between the off and on states is defined. If the device oscillates around this threshold value, the switching state is not defined and the switch itself will be jittering. For steering applications, the problem is an undefined (and at some points incorrect) steering direction. Therefore it would be of great benefit, if an EAP could be deactivated as fast as possible but without any oscillations during the deactivation phase.

The paper by Xiang, X., Alici, G., Mutlu, R., & Li, W. (2014); "How the type of input function affects the dynamic response of conducting polymer actuators" Smart Materials and Structures, 23, 11 discloses a method to improve the command following ability of a conducting polymer actuator, while minimizing the electric power consumption. A smooth input has been found to consume less electrical power than sharp inputs such as a step input with discontinuous higher-order derivatives. This work relates to slowly responding current-driven (ionic) actuators for which oscillations during the activation phase do not arise. Further, oscillations during the deactivation phase are not addressed.

WO 2004/040112 A1 shows a method for driving a piezoelectric (field-driven) material actuator by providing the electroactive material structure with an actuation voltage and driving the voltage from a first (higher) to a second (lower) level (this level being 0 or lower) by way of a transition function in form of a ramp function, the transition function occurring over a time of about 1 ms.

EP 0 995 599 A also shows such a method, in this case a transition from a higher to a (non-zero and positive) lower voltage via a ramp, the transition occurring over times of the order of a few microseconds.

As mentioned above, this invention relates in particular to field-driven electroactive polymer actuators. They are able to respond at high frequencies and consequently have been found to suffer from oscillation issues.

SUMMARY OF THE INVENTION

The invention is defined by the claims.

According to examples in accordance with an aspect of the invention, there is provided a field-driven electroactive material actuator, comprising:

an electroactive material structure; and

a driver for providing an actuation voltage to the electroactive material structure, wherein the driver is adapted to: drive the actuation voltage from a first voltage level to a second voltage level, the second voltage level being lower than the first voltage level, by way of a transition function, the transition function occurring over a transition time, wherein the transition function comprises a smoothing function, wherein the transition time is at least 0.5ms.

This arrangement is for low frequency voltage-driven EAP actuators. Rather than using a single step function to transition between the first and second voltages, a transition function is used that comprises a smoothing function and occurs over a time of at least 0.5ms. In this way, mechanical oscillations of the actuator can be prevented whilst maintaining a deactivation period which is as short as possible for the particular EAP technology.

In particular, the driver is most preferably adapted to drive the actuation voltage from a first voltage level to a second voltage level, the second voltage level being lower than the first voltage level, and lying between the first level and zero.

According to this set of preferred embodiments, the invention in particular concerns instances in which an electroactive material actuator is being partially deactivated, so as to reach a lower actuation level, by reducing the driving voltage to a level between the first level and zero. It is in this circumstance that the problem of oscillation is most acute. To explain, if the EAP is being fully deactivated, the applied voltage is being disconnected and accordingly the EAP will slowly discharge via its internal parallel resistance and finally will go back to its initial position. However, if the EAP is being partially deactivated, so as to reach a lower actuation level between the first level and zero, the EAP will be discharged via the output impedance of the driving circuit, which is typically far lower than the internal parallel resistance of the EAP itself. By using a transition function to move to the second voltage level that comprises a smoothing function and occurs over a time of at least 0.5ms, oscillation in such circumstances can be substantially avoided.

The specific gradient and shape of the smoothing function may be selected to find the best compromise between oscillation suppression and response speed.

In an embodiment, the smoothing function comprises at least one of: a ramp function; a parabolic function; and an exponential function.

In order to reduce and/or eliminate the oscillations generated by an EAP during a deactivation phase, the slope of the smoothing function, and so the transition function, should be as shallow as possible. The simplest way in which this can be realized is with a ramp like response, starting from the first voltage level and ending at the second voltage level with a single straight line. Accordingly, the ramp function occurs over a time of at least 0.5ms. In this case, the entire transition time relates to the smoothing function.

The transition time may be at least 1.0ms or at least 2.0ms or at least 5.0ms.

Other shapes may also be considered for the smoothing function, such as parabolic and exponential functions. In particular, an exponential waveform is simple to implement in an electronic system through the inclusion of a capacitor. In addition, the waveform shapes may be combined to form the smoothing function. For example, within a first time frame of the total transition time a ramp may be used, which may then be followed by an exponential function or a parabolic function in a second time frame.

In some embodiments, the smoothing function is approximated as a set of discrete points.

In further embodiments, the smoothing function further comprises interpolated data points between the discrete points.

The smoothing function selected to manage a deactivation transition of an EAP may be realized by a gradual approximation. For example, step functions, with or without any interpolated intermediate values, may be used, wherein the steps are chosen to reduce any oscillations to a reasonable amount. Interpolated values may be exactly on, or close to, the corresponding points of the smoothing function.

In some designs, the transition function further comprises at least one of: a first step function, between the first voltage level and the smoothing function; and a second step function, between the smoothing function and the second voltage level.

In this way, it is possible to increase the speed of the transition function whilst simultaneously preventing excessive oscillations.

In an arrangement, the actuator further comprises a feedback system adapted to detect oscillations of the electroactive material structure.

In a further arrangement, the feedback system comprises at least one of: a mechanical sensor; and an electrical sensor.

In a yet further arrangement, the driver is adapted to alter the drive voltage if the oscillations detected by the feedback system are above a threshold value.

Mechanical sensors used to detect actuator oscillations may include: a PVDF foil; a strain gauge; an optical distance/deflection sensor; or any other external sensor capable of detecting the mechanical oscillations of the actuator.

Electrical sensors may be adapted to detect oscillating changes in the driving signal/current of the actuator in order to identify mechanical oscillations. A simple implementation of this would be to connect a small resistor in series with the actuator.

As the sensors can only detect existing oscillations, a threshold value for an 'allowable' level of oscillations is included. If the threshold is exceeded, the driving signal is adapted accordingly.

In some embodiments, the transition function further comprises an anti-oscillation function, the anti-oscillation function having the same frequency as oscillations of the electroactive material structure.

The mechanical oscillations of a given EAP actuator depend on its design, such as its form, size and shape, its load condition and the deactivation requirements. Thus, for actuators with known oscillations, a specific transition signal may be generated, such as an initial step function followed by a dc-biased anti-oscillation function. In order to destructively interfere with the actuator oscillations, the frequency of the anti-oscillation function needs to match the oscillation frequency of the actuator.

In further embodiments, the anti-oscillation function has a phase shift between 170° and 190° relative to the oscillations of the electroactive material structure.

A phase shift of this magnitude allows the anti-oscillation function to achieve total destructive interference with the actuator oscillations.

In an embodiment, the driver comprises a memory adapted to store look-up tables of predetermined values for driving the actuation voltage.

In this way, the driver may have quick and reliable access to transition and smoothing functions to reduce and/or eliminate oscillations due to a planned deactivation of the EAP actuator.

In an arrangement, the actuator further comprises a microcontroller.

According to examples in accordance with an aspect of the invention, there is provided a method for driving a field-driven electroactive material actuator, the method comprising:

provizing an electroactive material structure with an actuation voltage; and
driving the actuation voltage from a first voltage level to a second voltage level, the second voltage level being lower than the first voltage, by way of a transition function, the transition function occurring over a transition time, wherein the transition function comprises a smoothing function, wherein the transition time is at least 0.5ms.

Preferably, the second voltage level lies between the first level and zero.

In an embodiment, the method further comprises approximating the smoothing functions as a set of discrete points.

In a further embodiment, the method further comprises interpolating data points between the discrete points.

BRIEF DESCRIPTION OF THE DRAWINGS

Examples of the invention will now be described in detail with reference to the accompanying drawings, in which:

Figure 1 shows a known EAP actuator, which is unconstrained and thus expands in plane;
Figure 2 shows a known EAP actuator, which is constrained and thus deforms output of plane;
Figure 3 shows the waveform of a conventional drive scheme and the response of an actuator to the drive waveform;

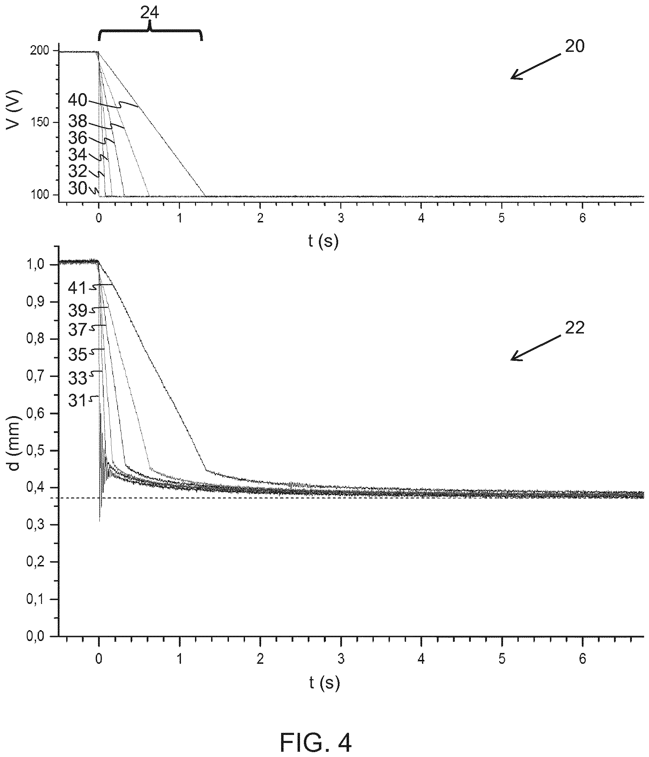

Figure 4 shows various waveforms of drive schemes according to several embodiments and the associated mechanical responses of an actuator;

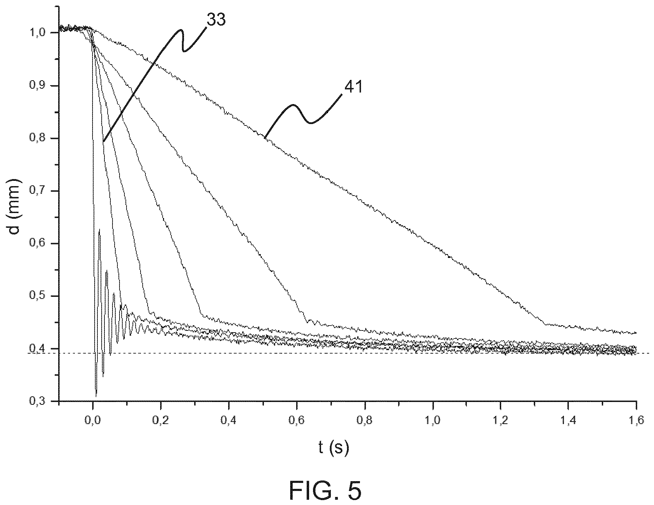

Figure 5 shows a more detailed view of the mechanical responses of the actuator in Figure 4;

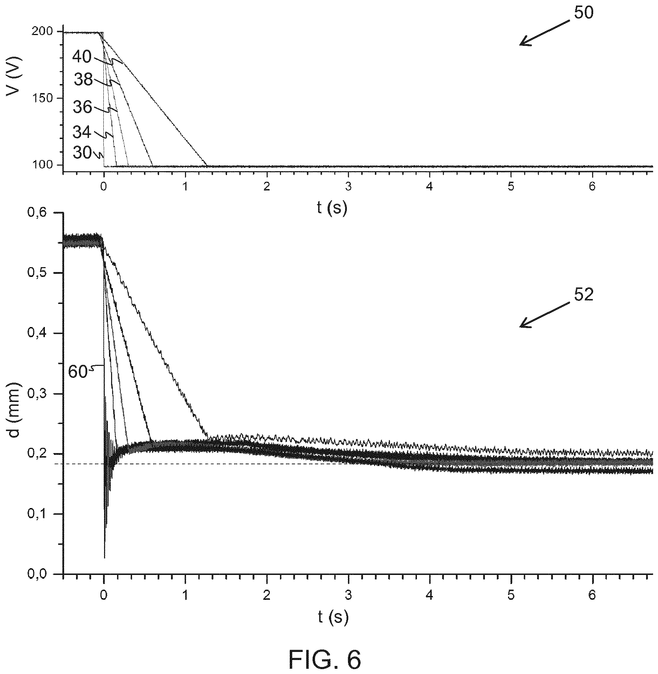

Figure 6 shows the waveforms of Figure 4 and the associated mechanical responses of an actuator that has previously undergone extensive use;

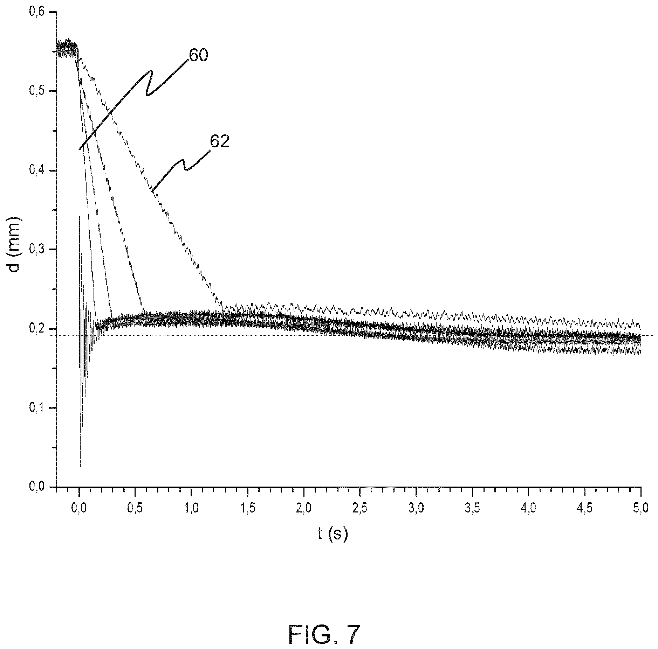

Figure 7 shows a more detailed view of the mechanical response of the actuator in Figure 6;

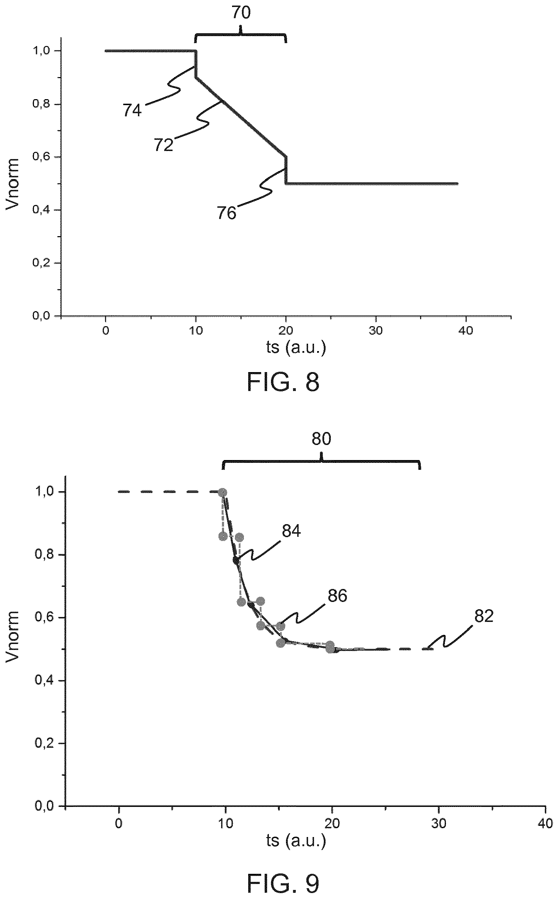

Figure 8 shows a waveform of a drive scheme according to an embodiment;

Figure 9 how the waveform may be stepped or approximated rather than smooth;

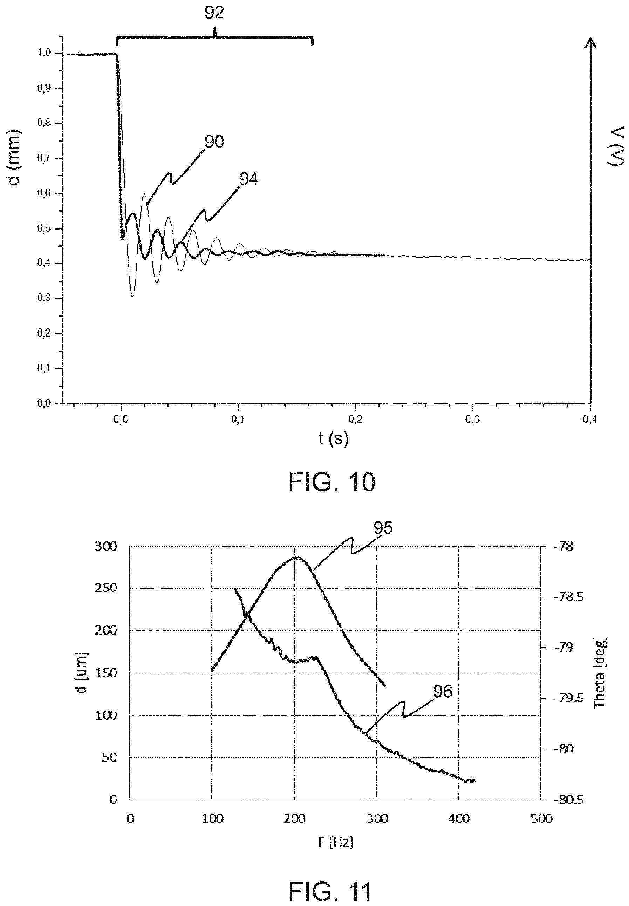

Figure 10 shows a waveform of a drive scheme that includes an anti-oscillation function;

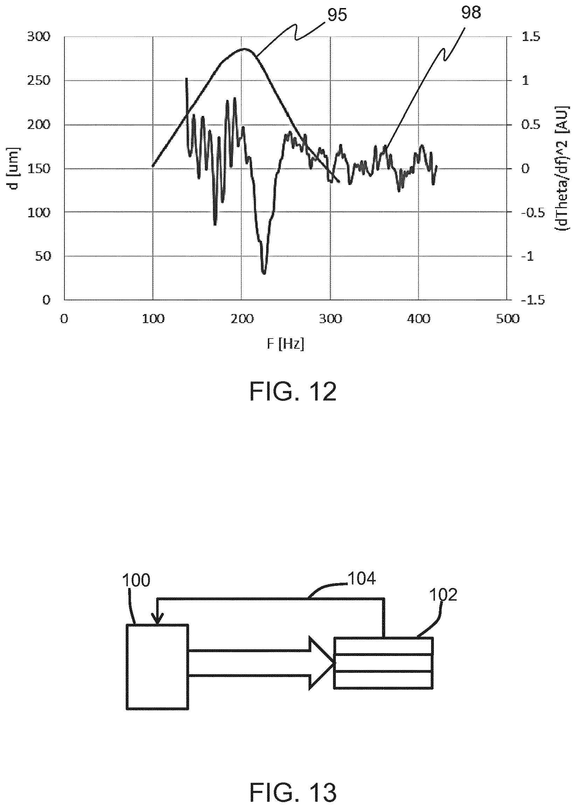

Figures 11 and 12 show a method for determining the oscillation frequency of an actuator;

Figure 13 shows an example driver for an EAP structure, in combination with a feedback system for detecting oscillations of the EAP structure; and

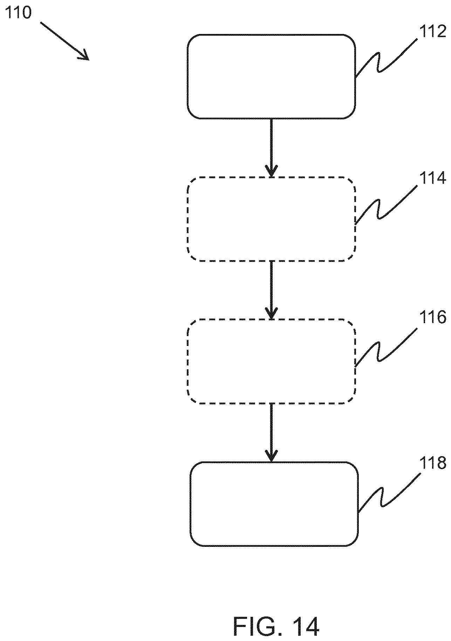

Figure 14 shows a block diagram of a method of driving a field-driven electroactive material actuator.

## DETAILED DESCRIPTION OF THE EMBODIMENTS

The invention provides a field-driven electroactive material actuator that is driven by an actuation voltage. A driver is adapted to drive the actuation voltage from a first voltage level to a second voltage level, wherein the second voltage level is lower than the first, by way of a transition function, which occurs over a transition time. The transition function includes a smoothing function. The transition time is at least 0.5ms.

Typically, an EAP is controlled by a driving circuit which provides the required electrical voltage to operate the component. If the EAP is being activated, the driver normally generates a step dc voltage with a certain amplitude to bring the EAP into the desired position. Since electronic driving circuits are not ideal (e.g. they always have internal resistances), the actuation response is not only a function of the EAP itself but also of the driving circuit. In order to reduce the impact of the driver, the operating voltage for the EAP is usually stored in a capacitor, parallel to the EAP, and in terms of actuation this stored voltage is fed by an electronic switch (e.g. transistor, MOSFET) to the EAP.

The EAP actuator then starts to deform as a function of its charge, which again depends on the applied voltage amplitude. If the EAP is being deactivated, the applied voltage is being disconnected and accordingly the EAP will slowly discharge via its internal parallel resistance and finally will go back to its initial position. If the EAP is being partially deactivated, so as to reach a lower actuation level, the driving voltage is reduced. In this case, the EAP will be discharged via the output impedance of the driving circuit, which is typically far lower than the internal parallel resistance of the EAP itself.

A problem is that the step decrease in voltage can give rise to mechanical oscillation. In particular, it has been observed by the applicant during experimental investigations that voltage (field) driven EAPs, operated by a rectangular voltage show strong oscillations during the deactivation phase, whereas a sinusoidal operation does not result in these oscillations. The oscillations during the deactivation phase are found to be caused by a sudden change of the control (actuation) voltage. Mathematically this can be described as the slope or voltage derivative dv/dt.

If this slope exceeds a threshold, oscillations have been found to appear. If the slope is limited by providing a transition function which follows one of a set of suitable mathematical smoothing functions, these oscillations can be reduced, or even fully or almost fully eliminated. A further measure to assist in providing a non-oscillating deactivation of an EAP is a smooth transition between the deactivation phase and the final steady state. Again, a large step in operating voltage may cause oscillations. The change in the voltage amplitude at this transition should thus also be limited. For example, at the point of transition between deactivation phase and the final steady state position, the slope or voltage derivative dv/dt may be small or zero.

In order to determine the most suitable mathematical smoothing functions for the deactivation transition function, various measurements have been made using a standard voltage-driven EAP actuator.

Table 1: Possible smoothing functions

| **Ramp** <br> Param eters | $$v_{ramp}(t) = m \cdot t + b$$ $$m = \frac{v_1 - v_0}{t_1 - t_0}$$ $$b = \frac{v_0 t_1 - v_1 t_0}{t_1 - t_0}$$ | *Equation 1* |
|---|---|---|

(continued)

| Parabolic<br>Param eters | $$v_{para}(t) = a + b \cdot t + c \cdot t^2$$ $$a = v_1 + \frac{(v_0 - v_1)}{(t_0 - t_1)^2} \cdot t_1^2$$ $$b = -2 \cdot \frac{(v_0 - v_1)}{(t_0 - t_1)^2} \cdot t_1$$ $$c = \frac{(v_0 - v_1)}{(t_0 - t_1)^2}$$ | Equation 2 |
|---|---|---|
| Exponential<br>Param eters | $$v_{exp}(t) = a + b \cdot (1 - e^{-\frac{t}{\tau}})$$ $$b = \frac{v_0 - v_1}{e^{-\frac{t_1}{\tau}} - e^{-\frac{t_0}{\tau}}}$$ $$a = v_1 - \frac{v_0 - v_1}{e^{-\frac{t_1}{\tau}} - e^{-\frac{t_0}{\tau}}} \cdot (1 - e^{-\frac{t_1}{\tau}})$$ $$\tau = \frac{t_1}{nrc}$$ $$nrc \approx 6$$ | Equation 3 |

The exemplary smoothing functions, given in Table 1, are limited to the time where the EAP is forced to change actuation state from an initial state to a lower one. Mathematically the corresponding time t is limited to: $t_0 < t \le t_1$ where $t_0$ is the point in time where the deactivation starts and $t_1$ is the point in time where the transition should end. Typically, this is the point in time where the EAP should reach its new actuation level. Further, $v_0$ is the actual voltage at to and $v_1$ is the required voltage at $t_1$.

The top graph 20 of Figure 4 shows six transition functions, plotted as voltage, V, against time, t, wherein each function comprises a ramp-like smoothing function with a different gradient. The transition occurs from a first voltage level of 200V to a second voltage level of 100V. The associated oscillatory EAP responses are plotted, as deflection, d, against time, in the lower graph 22. A transition function 24 is the function that covers the entire transition between the first voltage level and the second voltage level. In some cases, the smoothing function may occupy the entirety of the transition function, as shown in Figure 4; whereas, in other cases, the smoothing function may only occupy part of the transition function, as shown further below.

The leftmost transition function 30 of the top graph 20 shows the previously discussed step function typically used in conventional EAP actuator systems. In this case, the theoretical gradient of the transition function is infinitely negative, meaning the transition time is theoretically infinitely small, thereby resulting in large oscillations as shown in the corresponding leftmost signal 31 of the lower graph 22. The table below shows the approximate gradients used in each transition, and the corresponding plot in the bottom graph 22.

Table 2: Investigated slopes

| Function | Approx. Slope (V/s) | Mechanical response plot |
|---|---|---|
| 30 | -∞ (theoretically) | 31 |
| 32 | -1280 | 33 |
| 34 | -640 | 35 |
| 36 | -320 | 37 |
| 38 | -160 | 39 |
| 40 | -80 | 41 |

As can be readily seen from the lower graph 22, a reduction in the absolute value of the gradient of the transition, and so an increase in the transition time, leads to a significant reduction in the amplitude and number of oscillations observed in the EAP.

As shown in the table above, the absolute gradient may for example be less than 2kV/s, for example less than 20kV/s, for example less than 200kV/s. By having the transition shallower than a true step function, oscillations are reduced or avoided. A transition from 200V to zero for example may take place in 1ms or longer.

Figure 5 shows a more detailed view of the lower graph 22 of Figure 4. It can be seen that the oscillations are almost entirely eliminated for all investigated slopes. However, it can also be observed that the transition function with the lowest absolute gradient 41 results in a delayed response, meaning the target actuation point is reached somewhat later than desired, and may further result in a small offset. This offset may be avoided by driving to a slightly lower voltage than the exemplarily $v_1$ = 100V.

Such corrections could be stored by the driver in a look-up table for example. By increasing the absolute gradient of the transition function, and so reducing the transition time, the offset and the delay decrease. For this specific EAP, a transition function 32 with a gradient of about -1280 V/s comes closest to the original response but with severely reduced oscillations 33. This gradient leads to a transition time of approximately 0.8ms. The transition time may be decreased further; however, decreasing the transition time below 0.5ms may increase the risk of generating oscillations.

Figure 6 shows in graph 52 the mechanical response of five of the transition functions of Figure 4, as plotted in the graph 50, on an EAP that has undergone extensive use. The five functions are 30, 34, 36, 38 and 40 as defined in Table 2 above. The behavior of some EAPs may depend on their history, meaning that the operating/driving of the EAP in the past may have an impact on the actual performance. In addition, degradation over time may have a strong impact on the mechanical deformation. Further to this, the mechanical (deactivation) response may also depend on the required actuation level itself. More specifically, the mechanical response may depend on whether the target actuation level is close to the maximum, in the mid region or close to the minimum actuation level of the EAP. This is a consequence of the mechanisms leading to the activation and deactivation of EAP devices, such as: piezoelectric effect; capacitive effect; dipole effect; and microcrystalline ordering; and the fact that these mechanisms activate at different voltage ranges and different rates of change of voltages. Specifically, some mechanisms, such as the dipole and piezoelectric mechanisms have very fast response times whilst others, such as the microcrystalline ordering, are slow and are therefore very dependent on usage history. The mechanisms also behave differently when voltages are increased, decreased or removed entirely.

In contrast to the first set of measurements, shown in Figures 4 and 5, the second set of measurements, shown in Figures 6 and 7, presents the performance of another EAP, which has been used for several hours and under various driving conditions. The leftmost signal 60 of the lower graph 52 of Figure 6 shows the behavior of the EAP under a conventional step function 30. Comparing this to the corresponding signal 31 of Figures 4 and 5, depicting an unused EAP, a clear difference in the mechanical response can be observed. While in the first case the required actuation level is slowly reached, via an exponential decay, the final actuation level of the second EAP is reached after a slow local increase. In both cases the oscillations can be observed in response to the step-like transition function 30.

Figure 7 shows a detailed view of the lower graph 52 of Figure 6. As in the case of Figure 5, the transition function with the lowest absolute gradient 62 results in a delayed response and a small offset from the target actuation point. Once again, it was found that a transition time of approximately 0.8ms resulted in a desirable balance between the response time and the number of observed oscillations.

As discussed above, it is possible for the smoothing function to adopt a number of, or combination of, different shapes as shown in Table 1. In order to reduce, or prevent, the oscillations, the transition time, which may comprise one or more smoothing times, should be at least 0.5ms.

Figure 8 shows an embodiment of a transition function 70, which includes a smoothing function 72, plotted as normalized voltage, Vnorm, against time step, ts. The transition function further includes a first step function 74, between the first voltage level and the smoothing function, and a second step function 76, between the smoothing function and the second voltage level. In this way, the deactivation transition may be accelerated whilst simultaneously reducing, or preventing, the oscillations.

Figure 9 shows a transition function 80, which includes an exponential smoothing function 82, shown by the dashed line. In the case where an exponential function cannot be perfectly reproduced, the smoothing function may be realized by gradual approximations, such as step functions with interpolated values, shown by the solid line 84, or without interpolated values, shown by the dashed line 86. The interpolated values may be exactly on, or close to, the corresponding points of the smoothing function. By performing this approximation of the smoothing function, it is possible to reduce the processing power and/or complexity of the system required to drive the actuation voltage of the EAP.

Figure 10 shows the mechanical oscillations 90, with respect to the deflection axis, d, of an actuator in response to a conventional step transition function. In addition, the graph depicts an exemplary transition function 92, with respect to the voltage axis, V, which includes an anti-oscillation function 94.

As discussed above, the observed oscillations of a specific EAP depend on its design, load condition and the (de)actuation requirements. Thus, for actuators with known oscillations, a specific deactivation signal may be generated. For example, a step-wise response may be used initially, followed by a dc-biased anti-oscillation function 94. The anti-oscillation function needs to have the same frequency as the mechanical oscillations, but shifted in phase by about 180° in order to achieve destructive interference. More specifically, in order to pro-actively compensate the mechanical oscillations, the phase shift needs to be adapted so that the driving signal is leading by slightly less than 180°.

Since the oscillation frequency is dependent on EAP geometry, clamping, history and driving voltage, it is necessary to determine the exact oscillation frequency just before de-actuation occurs in order to achieve maximum effectiveness of the anti-oscillation function. An electrical measurement of the typical oscillation frequency of the EAP can be used to determine the anti-oscillation amplitude. This eliminates the need for feedback on the amplitude of the EAP oscillations, for example by using an additional sensor.

The oscillation frequency of the EAP can be determined by driving a small AC voltage signal on top of the primary actuation voltage. This small AC voltage signal is small enough to avoid adding extra mechanical deformations to the EAP, but can still be measured electronically. Typically, the small AC voltage signal will be <1% of the primary actuation voltage.

Figures 11 and 12 show, as plot 95, the deflection of an EAP due to an actuation voltage and the impedance of the EAP, as plot 96, measured by a small AC voltage-driven at a range of frequencies. The imaginary part of the impedance, indicated by the Theta scale, is dependent on the oscillation frequency as can be seen in Figure 11. By taking the $2^{nd}$ derivative of the impedance, shown in Figure 12 as plot 98, the position of the oscillation frequency can be easily determined from the anti-resonance frequency, $f_{ar}$, with a typical accuracy of 10%. In this case, the threshold can be set at -1. In fact, the anti-resonance frequency in damped electromechanical systems, such as EAPS, is typically 10% higher than the resonance frequency. Therefore, a more accurate driving frequency of the anti-oscillation function is $0.9*f_{ar}$.

Figure 13 shows that a driver 100 is used to apply the drive voltage to the EAP structure 102. It also shows an optional feedback system 104, which may include mechanical, optical and/or electrical sensors. The feedback system may allow the driver 100 to alter the drive voltage of the EAP, in order to compensate for any oscillations that are detected. This may not allow for the prevention of oscillations as the feedback system is only capable of detecting existing oscillations. As such, it may be necessary to include an allowable oscillation threshold, over which, the driver is adapted to begin oscillation compensation.

In order to generate the required transition function, several implementations may be used. Basic analogue circuits may be employed in some cases, such as using a capacitor to generate an exponential smoothing function. Further, a digital-microcontroller may calculate the required analogue data points for the transition function, which may then be amplified by any conventional power amplifier solution.

Further still, a look-up table approach might be implemented; where all required data points are pre-calculated and saved in a memory within the driver, or other suitable controlling device. The digital or analogue data points may then be read out as a function of time.

Figure 14 shows a method 110 of the invention.

In step 112, an EAP structure is provided with an actuation voltage.

In step 114, a smoothing function may be approximated as a set of discrete points.

In step 116, data points may be interpolated between the discrete data points in order to better approximate the original smoothing function.

In step 118, the actuation voltage is driven from a first voltage level to a second voltage level, wherein the first voltage level is higher than the second, by way of a transition function, the transition function occurring over a transition time. The transition function at least partially comprises a smoothing function, wherein transition time is at least 0.5ms.

This invention relates in particular to actuation of EAP actuators. However, it can be used in applications where an EAP device is performing both a sensing and an actuation function.

Although in the detailed description herein above the construction and operation of devices and systems according to the invention have been described for EAPs, the invention can in fact be used for devices based on other kinds of EAM material. Hence, unless indicated otherwise, the EAP materials hereinabove can be replaced with other EAM materials. Such other EAM materials are known in the art and the person skilled in the art will know where to find them and how to apply them.

Materials suitable for an EAP layer are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:
Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to:
acrylates, polyurethanes, silicones.

The sub-class conjugated polymers includes, but is not limited to:
polypyrrole, poly-3,4-ethylenedioxythiophene, poly(p-phenylene sulfide), polyanilines.

In all of these examples, additional passive layers may be provided for influencing the electrical and/or mechanical behavior of the EAP layer in response to an applied electric field.

The EAP layer of each unit may be sandwiched between electrodes. The electrodes may be stretchable so that they follow the deformation of the EAP material layer. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

If the electrodes are arranged in a non-symmetric configuration, the imposed voltage can induce all kinds of deformations such as twisting, rolling, torsioning, turning, and non-symmetric bending deformation.

The invention can be applied in many EAP and polymer applications, including examples where a passive matrix array of actuators is of interest.

In many applications the main function of the product relies on the (local) manipulation of human tissue, or the actuation of tissue contacting interfaces. In such applications EAP actuators for example provide unique benefits mainly because of the small form factor, the flexibility and the high energy density. Hence EAP's and photoresponsive polymers can be easily integrated in soft, 3D-shaped and / or miniature products and interfaces. Examples of such applications are:

Skin cosmetic treatments such as skin actuation devices in the form of a responsive polymer based skin patches which apply a constant or cyclic stretch to the skin in order to tension the skin or to reduce wrinkles;

Respiratory devices with a patient interface mask which has a responsive polymer based active cushion or seal, to provide an alternating normal pressure to the skin which reduces or prevents facial red marks;

Electric shavers with an adaptive shaving head. The height of the skin contacting surfaces can be adjusted using responsive polymer actuators in order to influence the balance between closeness and irritation;

Oral cleaning devices such as an air floss with a dynamic nozzle actuator to improve the reach of the spray, especially in the spaces between the teeth. Alternatively, toothbrushes may be provided with activated tufts;

Consumer electronics devices or touch panels which provide local haptic feedback via an array of responsive polymer transducers which is integrated in or near the user interface;

Catheters with a steerable tip to enable easy navigation in tortuous blood vessels;

Measurements of physiological human body parameters such as heart beat, SpO2 and blood pressure.

Another category of relevant application which benefits from such actuators relates to the modification of light. Optical elements such as lenses, reflective surfaces, gratings etc. can be made adaptive by shape or position adaptation using these actuators. Here one benefit of EAPs for example is a lower power consumption.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

**Claims**

1. A field-driven electroactive material actuator, comprising:

    an electroactive material structure (102); and
    a driver (100)for providing an actuation voltage to the electroactive material structure, wherein the driver is adapted to:
    drive the actuation voltage from a first voltage level to a second voltage level, the second voltage level being lower than the first voltage level, and lying between the first level and zero, by way of a transition function (24), the transition function occurring over a transition time, wherein the transition function comprises a smoothing function (82), wherein the transition time is at least 0.5ms.

2. An actuator as claimed in claim 1, wherein the smoothing function (72) comprises at least one of: a ramp function; a parabolic function; and an exponential function.

**3.** An actuator as claimed in any preceding claim, wherein the smoothing function (82) is approximated as a set of discrete points (86).

**4.** An actuator as claimed in claim 3, wherein the smoothing function (82) further comprises interpolated data points (84) between the discrete points (86).

**5.** An actuator as claimed in any preceding claim, wherein the transition function (24) further comprises at least one of: a first step function (74), between the first voltage level and the smoothing function; and a second step function (76), between the smoothing function and the second voltage level.

**6.** An actuator as claimed in any preceding claim, wherein the actuator further comprises a feedback system (104) adapted to detect oscillations of the electroactive material structure (102).

**7.** An actuator as claimed in claim 6, wherein the feedback system (104) comprises at least one of: a mechanical sensor; and an electrical sensor.

**8.** An actuator as claimed in claims 6 or 7, wherein the driver (100) is adapted to alter the drive voltage if the oscillations detected by the feedback system (104) are above a threshold value.

**9.** An actuator as claimed in any preceding claim, wherein the transition function further comprises an anti-oscillation function (94), the anti-oscillation function having the same frequency as oscillations of the electroactive material structure.

**10.** An actuator as claimed in claim 9, wherein the anti-oscillation function (94) has a phase shift between 170° and 190° relative to the oscillations of the electroactive material structure.

**11.** An actuator as claimed in any preceding claim, wherein the driver (100) comprises a memory adapted to store look-up tables of predetermined values for driving the actuation voltage.

**12.** An actuator as claimed in any preceding claim, wherein the actuator further comprises a microcontroller.

**13.** A method (110) for driving a field-driven electroactive material actuator, the method comprising:

providing (112) an electroactive material structure with an actuation voltage; and
driving (118) the actuation voltage from a first voltage level to a second voltage level, the second voltage level being lower than the first and lying between the first level and zero, by way of a transition function, the transition function occurring over a transition time, wherein the transition function comprises a smoothing function, wherein the transition time is at least 0.5ms.

**14.** A method as claimed in claim 13, wherein the method further comprises approximating (114) the smoothing functions as a set of discrete points.

**15.** A method as claimed in claim 14, wherein the method further comprises interpolating (116) data points between the discrete points.

**Patentansprüche**

**1.** Ein Feld-gesteuerter elektroaktiver Materialaktor, der Folgendes umfasst:

eine elektroaktive Materialstruktur (102); und
ein Treiber (100), der die elektroaktive Materialstruktur mit einer Betätigungsspannung versorgt, wobei der Treiber folgende Schritte durchführt:
Ansteuern der Betätigungsspannung von einem ersten auf einen zweiten Spannungspegel, wobei der zweite Spannungspegel niedriger ist als der erste und zwischen dem ersten Pegel und Null liegt. Dies erfolgt mithilfe einer Übergangsfunktion (24), die über eine Übergangszeit von mindestens 0,5 ms auftritt, und die über eine Glättungsfunktion (82) verfügt.

**2.** Ein Aktor gemäß Anspruch 1, wobei die Glättungsfunktion (72) mindestens eine der folgenden Funktionen umfasst: eine Rampenfunktion; eine Parabolfunktion; und eine Exponentialfunktion.

**3.** Ein Aktor gemäß einer der vorhergehenden Ansprüche, wobei die Glättungsfunktion (82) als ein Satz diskreter Punkte (86) geschätzt wird.

**4.** Ein Aktor gemäß Anspruch 3, wobei die Glättungsfunktion (82) zudem über interpolierte Datenpunkte (84) zwischen den diskreten Punkten (86) verfügt.

**5.** Ein Aktor gemäß einer der vorhergehenden Ansprüche, wobei die Übergangsfunktion (24) zudem über mindestens eine der folgenden Funktionen verfügt: eine erste Schrittfunktion (74) zwischen dem ersten Spannungspegel und der Glättungsfunktion; und eine zweite Schrittfunktion (76) zwischen der Glättungsfunktion und dem zweiten Spannungspegel.

**6.** Ein Aktor gemäß einer der vorhergehenden Ansprüche, wobei der Aktor zudem über ein Feedbacksystem (104) verfügt, dass Schwingungen der elektroaktiven Materialstruktur (102) erkennt.

**7.** Ein Aktor gemäß Anspruch 6, wobei das Feedbacksystem (104) mindestens einen der beiden folgenden Sensoren umfasst; ein mechanischen Sensor und einen elektrischen Sensor.

**8.** Ein Aktor gemäß Anspruch 6 oder 7, wobei der Treiber (100) die Antriebsspannung ändert, wenn die vom Feedbacksystem (104) erkannten Schwingungen über einem Schwellenwert liegen.

**9.** Ein Aktor gemäß einer der vorhergehenden Ansprüche, wobei die Übergangsfunktion zudem eine schwingungstilgende Funktion (94) umfasst, die über dieselbe Frequenz wie die Schwingungen der elektroaktiven Materialstruktur verfügt.

**10.** Ein Aktor gemäß Anspruch 9, wobei die schwingungstilgende Funktion (94) relativ zu den Schwingungen der elektroaktiven Materialstruktur über eine Phasenverschiebung zwischen 170° und 190° verfügt.

**11.** Ein Aktor gemäß einer der vorhergehenden Ansprüche, wobei der Treiber (100) über einen Speicher verfügt, auf dem Suchtabellen mit vorab festgelegten Werten für das Ansteuern der Betätigungsspannung gespeichert sind.

**12.** Ein Aktor gemäß einer der vorhergehenden Ansprüche, wobei der Aktor zudem über einen Mikrocontroller verfügt.

**13.** Eine Methode (110) zum Antreiben eines Feldgesteuerten elektroaktiven Materialaktors, wobei die Methode folgende Schritte umfasst:

Bereitstellen (112) einer elektroaktiven Materialstruktur mit einer Betätigungsspannung; und
Ansteuern (118) der Betätigungsspannung von einem ersten auf einen zweiten Spannungspegel, wobei der zweite Spannungspegel niedriger ist als der erste und zwischen dem ersten Pegel und Null liegt. Dies erfolgt mithilfe einer Übergangsfunktion, die über eine Übergangszeit von mindestens 0,5 ms auftritt, und die über eine Glättungsfunktion verfügt.

**14.** Eine Methode gemäß Anspruch 13, wobei die Methode zudem das Schätzen (114) der Glättungsfunktionen als einen Satz diskreter Punkte umfasst.

**15.** Eine Methode gemäß Anspruch 14, wobei die Methode zudem das Interpolieren (116) von Datenpunkten zwischen den diskreten Punkten umfasst.

**Revendications**

**1.** Actionneur à matière électroactive excité par un champ, comprenant :

une structure de matière électroactive (102) ; et
un excitateur (100) pour fournir une tension d'actionnement à la structure de matière électroactive, dans lequel ledit excitateur est conçu :

pour exciter la tension d'actionnement d'un premier niveau de tension à un second niveau de tension, le second niveau de tension étant inférieur au premier niveau de tension, et se situant entre le premier niveau et zéro, au moyen d'une fonction de transition (24), ladite fonction de transition se produisant sur un temps de transition, dans lequel la fonction de transition comprend une fonction de lissage (82), dans lequel le temps de transition est d'au moins 0,5 ms.

2. Actionneur selon la revendication 1, dans lequel la fonction de lissage (72) comprend : une fonction de rampe et/ou une fonction parabolique et/ou et une fonction exponentielle.

3. Actionneur selon l'une quelconque des revendications précédentes, dans lequel la fonction de lissage (82) est approximée en tant qu'un ensemble de points discrets (86).

4. Actionneur selon la revendication 3, dans lequel la fonction de lissage (82) comprend en outre des points de données interpolés (84) entre les points discrets (86).

5. Actionneur selon l'une quelconque des revendications précédentes, dans lequel la fonction de transition (24) comprend en outre : une première fonction de pas (74), entre le premier niveau de tension et la fonction de lissage ; et/ou une seconde fonction de pas (76), entre la fonction de lissage et le second niveau de tension.

6. Actionneur selon l'une quelconque des revendications précédentes, dans lequel l'actionneur comprend en outre un système de rétroaction (104) conçu pour détecter les oscillations de la structure de matière électroactive (102).

7. Actionneur selon la revendication 6, dans lequel le système de rétroaction (104) comprend : un capteur mécanique et/ou un capteur électrique.

8. Actionneur selon les revendications 6 ou 7, dans lequel l'excitateur (100) est conçu pour modifier la tension de commande lorsque les oscillations détectées par le système de rétroaction (104) sont supérieures à une valeur seuil.

9. Actionneur selon l'une quelconque des revendications précédentes, dans lequel la fonction de transition comprend en outre une fonction anti-oscillation (94), ladite fonction anti-oscillation présentant la même fréquence que les oscillations de la structure de matière électroactive.

10. Actionneur selon la revendication 9, dans lequel la fonction anti-oscillation (94) présente un déphasage dans la plage comprise entre 170 ° et 190 ° par rapport aux oscillations de la structure de matière électroactive.

11. Actionneur selon l'une quelconque des revendications précédentes, dans lequel l'excitateur (100) comprend une mémoire conçue pour mémoriser des tables de recherche des valeurs prédéterminées pour commander la tension d'actionnement.

12. Actionneur selon l'une quelconque des revendications précédentes, dans lequel l'actionneur comprend en outre un microcontrôleur.

13. Procédé (110) d'excitation d'un actionneur de matière électroactive excité par un champ, ledit procédé comprenant :

la fourniture (112) d'une structure de matière électroactive présentant une tension d'actionnement ; et la commande (118) de la tension d'actionnement d'un premier niveau de tension à un second niveau de tension, le second niveau de tension étant inférieur au premier et se situant entre le premier niveau et zéro, au moyen d'une fonction de transition, ladite fonction de transition se produisant sur un temps de transition, dans lequel la fonction de transition comprend une fonction de lissage, dans lequel le temps de transition est d'au moins 0,5 ms.

14. Procédé selon la revendication 13, dans lequel ledit procédé comprend en outre l'approximation (114) des fonctions de lissage sous la forme d'un ensemble de points discrets.

15. Procédé selon la revendication 14, dans lequel ledit procédé comprend en outre l'interpolation (116) des points de données entre les points discrets.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

110

112

114

116

118

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004040112 A1

- EP 0995599 A

**Non-patent literature cited in the description**

- **XIANG, X. ; ALICI, G. ; MUTLU, R. ; LI, W.** How the type of input function affects the dynamic response of conducting polymer actuators. *Smart Materials and Structures,* 2014, vol. 23, 11